# EUROPÄISCHE PATENTANMELDUNG

(11) **EP 0 530 145 A1**
(43) Veröffentlichungstag der Anmeldung: **03.03.1993**
(21) Anmeldenummer: 92810630.1
(22) Anmeldetag: 18.08.1992
(51) Int. Cl.: G03G 5/06, G11B 7/24, H01L 31/0344

(54) **Beschichtetes Material und dessen Verwendung**

(30) Priorität: 26.08.1991 CH 2495/91
(71) Anmelder: CIBA-GEIGY AG, CH-4002 Basel (CH)
(72) Erfinder: Mizuguchi, Jin, Dr., CH-1700 Fribourg (CH); Giller, Gérald, CH-1630 Bulle (CH); Rochat, Alain Claude, Dr., CH-1700 Fribourg (CH)

(57) **Zusammenfassung**

Beschichtete Materialien, bei dem auf einem Träger eine Schicht aus einem Pyrrolopyrrol der Formel I aufgebracht ist, 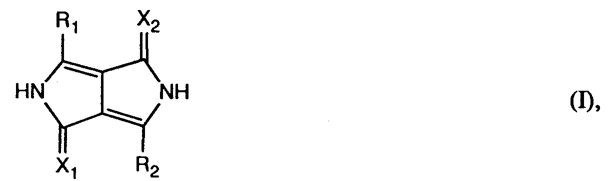
worin R₁ und R₂ beispielsweise 4-Pyridyl bedeuten, und X₁ und X₂ für O stehen, wobei die Verbindungen der Formel I mindestens teilweise als Salze von starken Säuren ausgebildet sind, eignen sich als optisches Aufzeichnungsmaterial und auf Grund deren elektrischen Leitfähigkeit und Photoleitfähigkeit als antistatisch ausgerüstete Materialien, Sensoren, Photorezeptoren und Solarbatterien.

## Beschreibung

Die Erfindung betrifft ein beschichtetes Material, bei dem ein Träger auf mindestens einer Seite mit einem Pyrrolopyrrol beschichtet ist, und das Pyrrolopyrrol mit Säuredämpfen in entsprechende Salze der Säuren übergeführt ist, ein Verfahren zur Speicherung und zum Ablesen von Informationen durch Laserbestrahlung der Pyrrolopyrrolschicht des besagten Trägers, das so beschriftete Material, die Verwendung so beschichteter elektrisch leitender Substrate als Photorezeptoren, für Solarbatterien und Sensoren, sowie die Verwendung von so beschichten dielektrischen Trägern als antistatisch ausgerüstete Materialien.

Optische Aufzeichnungsträger und -medien zur Speicherung von Informationen sind bekannt. [Vgl. z.B. "Farbmittel/Polymer-Systeme als Datenspeicher" von G. Kämpf et al, in Kunststoffe S. 1077- 1081, Carl Hanser Verlag, München 1986; oder "Erasable laser recording in an organic dye-binder optical disk medium ", von M.C. Gupta et al, in J. Appl. Phys. 60(8), 1986, S. 2932-2937.] Dabei erfolgt das Aufzeichnen der Informationen durch Behandlung mit Licht bestimmter Wellenlängen und Intensität oder mit anderen geeigneten energiereichen Strahlen, wie z.B. mit einem Laser. Durch Absorption der Strahlung tritt an den bestrahlten Stellen lokale Erwärmung ein, so dass an der Oberfläche des Aufzeichnungsträgers und/oder -mediums durch Verdampfen, Erweichen oder Schmelzen Vertiefungen erzeugt werden oder lokale Phasenumwandlungen erzeugt werden, welche zu einer Veränderung des Brechungsindexes, der Absorption oder der Reflexion führen. Mittels Laser lassen sich z.B. Löcher, Blasen oder Vertiefungen von etwa 1 bis einige µm² Grösse erzeugen, oder eine Phasenumwandlung bewirken, wobei das Ablesen dieser Informationen ebenfalls mittels eines Lasers geringerer Intensität unter Ausnutzung des geänderten Reflexions- bzw. Lichtstreuverhaltens dieser Löcher/Blasen/Vertiefungen oder Phasenumwandlung geschieht. Geeignete Aufzeichnungsmaterialien sind z.B. Metalle, Metalloxide, Kunststoffe oder sonstige lichtabsorbierende Schichten enthaltend z.B. Farbstoffe.

Die EP-A-401,791 offenbart, dass man die Veränderung des Absorptionsspektrums und/oder die Veränderung der Photoleitfähigkeit bestimmter organischer Verbindungen nach deren Behandlung mit einem organischen Lösungsmittel zur Speicherung von Informationen anwenden kann. Dabei wird die Oberfläche der organischen Aufzeichnungsschicht entsprechend der Form der zu markierenden Information mit einem organischen Lösungsmittel im flüssigen oder gasförmigen Zustand behandelt, z.B. durch Besprühen der Oberfläche aus einer Düse, wie beispielsweise einer Tintenstrahldrucker-("ink-jet-printer")-Einrichtung.

Es wurde nun überraschend gefunden, dass die Behandlung einer dünnen Schicht von Pyrrolopyrrol-Verbindungen auf einem Träger mit Dämpfen einer starken Säure zu einer ausgeprägten hypsochromen oder batochromen und reversiblen Verschiebung der Absorptionsmaxima führt, was mit einem deutlichen Farbwechsel verbunden ist. Solche Schichtmaterialien eignen sich daher hervorragend als optisches Aufzeichnungsmaterial zur Speicherung und Wiedergabe von Informationen durch Bestrahlung mit Laserlicht, wobei die säurebehandelte Schicht als photoempfindliche Schicht dient. Die hypsochrome oder batochrome Verschiebung kann in überraschend einfacher Weise durch Einwirkung von Wärme oder durch blosses Waschen mit Wasser wieder rückgängig gemacht werden. Solche säurebehandelten Schichten können auch zur antistatischen Ausrüstung von dielektrischen Materialien verwendet werden.

Es wurde ferner überraschend gefunden, dass ein solches mit Säuredämpfen behandeltes Schichtmaterial im Gegensatz zu unbehandelten Schichtmaterialien einen niedrigeren elektrischen Widerstand (verbesserte Dunkelleitfähigkeit) und eine ausgezeichnete Photoleitfähigkeit aufweisen, die durch Behandlung mit Halogenen, zum Beispiel Brom, noch erheblich verbessert werden kann. Die Schichtmaterialien können daher auch zur Herstellung von Photoreceptoren, Solarbatterien und Sensoren verwendet werden.

Ein Gegenstand der Erfindung ist ein beschichtetes Material, bei dem ein Träger auf mindestens einer Seite mit einer dünnen Schicht eines Pyrrolopyrrols der Formel I oder Mischungen von Pyrrolopyrrolen der Formel I beschichtet ist, 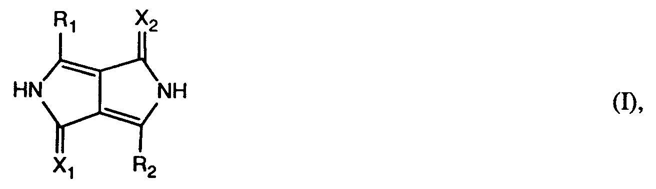
worin R₁ einen mit einer tert. Aminogruppe substituierten Phenyl- oder Pyridylrest der Formeln 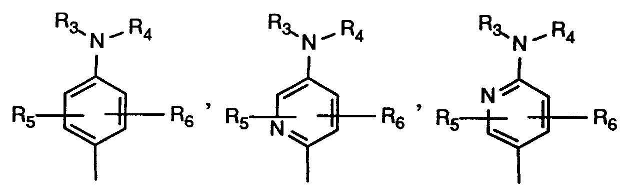
bedeutet oder eine Pyridylgruppe der Formel 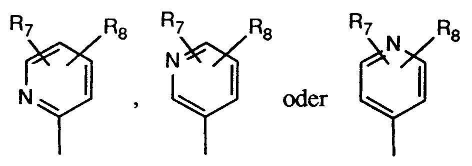
ist, R₂ eine Gruppe 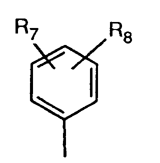
ist oder die gleiche Bedeutung wie R₁ hat, R₃ und R₄ unabhängig voneinander C₁-C₁₈-Alkyl, C₅-C₆-Cycloalkyl, durch -OH oder -SH substituiertes C₁-C₁₈-Alkyl oder unsubstituiertes oder durch Halogen, C₁-C₁₂-Alkyl, C₁-C₁₂-Alkoxy, Cyano oder Nitro substituiertes Phenyl, Benzyl oder Phenylethyl bedeuten oder zusammen mit dem N-Atom, an das sie gebunden sind, einen 5- oder 6-gliedrigen heterocyclischen Rest ausgewählt aus der Gruppe bestehend aus Pyrrolidinyl, Piperidyl, Pyrrolyl, Imidazolyl, pyrazolyl, Triazolyl, Piperazinyl, Morpholinyl und Thiomorpholinyl bilden, R₅ bis R₈ unabhängig voneinander Wasserstoff, Halogen, C₁-C₁₂-Alkyl, C₁ -C₁₂-Alkoxy, C₁-C₁₂-Alkylmerkapto oder Cyano bedeuten, und X₁ und X₂ unabhängig voneinander O oder S sind, wobei die Verbindungen der Formel I zumindest teilweise in Salze von starken Säuren übergeführt sind.

Als Träger kommen je nach endgültigem Verwendungszweck die unterschiedlichsten Materialien in Frage, zum Beispiel Papier, Glas, Keramiken, Kunststoffe, Laminate, Metalle und Metallegierungen und Metalloxide. Die Träger können je nach Verwendung opak oder transparent sein.

Die Schicht aus den Verbindungen der Formel I kann eine Dicke von 500 bis 5000 Å, bevorzugt 500 bis 4000 Å, besonders bevorzugt 500 bis 3000 Å und insbesondere bevorzugt 500 bis 2000 Å aufweisen.

Die Schicht aus den Verbindungen der Formel I kann teilweise oder vollständig in Salze von starken Säuren übergeführt sein, je nach Behandlungsdauer der Schicht aus den Verbindungen der Formel I mit starken Säuren. Für die Behandlung mit Säuren können wässrige Lösungen oder vorteilhafter Säuredämpfe verwendet werden. Für die erfindungsgemässen Zwecke genügt im allgemeinen eine kurze Behandlungszeit im Bereich von einigen Sekunden, wobei dann im wesentlichen nur die Oberfläche der Schicht aus den Verbindungen der Formel I in Salze übergeführt wird.

Die Schicht aus Verbindungen der Formel I wird bevorzugt mit Dämpfen einer starken Säure integral (d.h. auf der gesamten Oberfläche) behandelt, wobei es zu einer batho- oder hypsochromen Verschiebung des Absorptionsmaximums kommt. Für diese Säurebehandlung ist im Prinzip jede starke Säure geeignet, die bei Raumtemperatur einen genügend hohen Dampfdruck aufweist. Beispiele geeigneter Säure sind Salpetersäure, Salzsäure, Bromwasserstoffsäure, Trichloressigsäure und Trifluoressigsäure. Dabei wird Salpetersäure besonders bevorzugt. Der Farbumschlag erfolgt im allgemeinen bereits nach einer kurzen Säurebehandlung, beispielsweise nachdem die Schicht während ca. 5 Sekunden Salpetersäuredämpfen ausgesetzt wurde.

Ein weiterer Gegenstand der Erfindung ist ein Verfahren zur Herstellung des erfindungsgemässen Materials, bei dem man einen Träger, von dem mindestens eine Oberfläche mit einem Pyrrolopyrrol der Formel I beschichtet ist, mit einer starken Säure in Kontakt bringt und die Pyrrolopyrrole der Formel I mindestens teilweise in Salze besagter Säuren überführt.

Verbindungen der Formel I sind bekannt und können nach bekannten Methoden hergestellt werden. Verbindungen der Formel I, worin X₁ und X₂ O bedeuten, sowie deren Herstellung sind im US 4,579, 184 sowie in der EP-A 353, 184 beschrieben. Verbindungen der Formel I, worin X₁ und/oder X₂ S bedeuten, sind im US 4,632,893 beschrieben bzw. können nach den dort beschriebenen Methoden, z.B. durch Thionierung der entsprechenden Diketopyrrolopyrrole (d.h. Verbindungen, worin X₁ und X₂ O sind), hergestellt werden.

Ist einer der Substituenten R₅ bis R₈ der Verbindungen der Formel I Halogen oder sind Gruppen R₃ und R₄ durch Halogen substituiert versteht man darunter z.B. Iod, Fluor und insbesondere Chlor oder Brom.

Beispiele von C₁-C₁₈-Alkylgruppen sind Methyl, Ethyl, n-Propyl, Isopropyl, n-Butyl, sec.-Butyl, tert.-Butyl, n-Pentyl, tert.Amyl, n-Hexyl, 1,1,3,3-Tetramethylbutyl, n-Heptyl, n-Octyl, Nonyl, Decyl, Undecyl, Dodecyl,Tetradecyl, Heptadecyl und Octadecyl.

Beispiele von C₁-C₁₂-Alkoxygruppen sind Methoxy, Ethoxy, Propoxy, Isopropoxy, n-Butoxy, sec.-Butoxy, tert.-Butoxy, n-Pentyloxy, tert.-Amyloxy, n-Hexyloxy, n-Heptyloxy, n-Octyloxy, Decyloxy und Dodecyloxy.

Beispiele von C₁-C₁₂-Alkylmerkaptogruppen entsprechen den oben erwähnten C₁-C₁₂-Alkoxygruppen.

Beispiele von C₅-C₆-Cycloalkylgruppen sind Cyclopentyl und insbesondere Cyclohexyl.

Falls R₃ und R₄ substituiertes Phenyl, Benzyl oder Phenylethyl bedeuten, enthalten sie vorzugsweise einen der oben erwähnten Substituenten. Besonders bevorzugt sind unsubstituierte Reste.

Bevorzugte Verbindungen der Formel I sind zum Beispiel solche, worin jeweils die Gruppen R₁ und R₂, X₁ und X₂, R₃ und R₄, R₅ und R₆ bzw. R₇ und R₈ gleich sind.

Bevorzugt sind auch Verbindungen, worin R₁ Pyridyl oder eine Gruppe 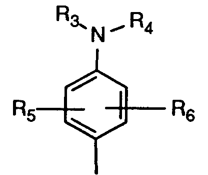
und R₂ eine Gruppe 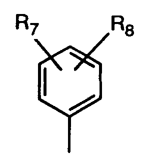
oder R₁ bedeuten, worin R₃ und R₄ gleich sind und C₁-C₁₂-Alkyl, 2-Hydroxyethyl, 2-Mercaptoethyl, Cyclohexyl, Benzyl oder Phenylethyl bedeuten oder zusammen mit dem N-Atom, an das sie gebunden sind, Pyrrolidinyl, Piperidyl, Morpholinyl oder Thiomorpholinyl bilden, und R₅ bis R₈ unabhängig voneinander Wasserstoff, Chlor, Brom, C₁-C₄-Alkyl, C₁-C₄-Alkoxy oder C₁-C₄-Alkylmerkapto bedeuten.

Besonders bevorzugt werden Verbindungen, worin R₃ und R₄ gleich sind und C₁-C₄-Alkyl, 2-Hydroxyethyl oder 2-Mercaptoethyl bedeuten oder zusammen mit dem N-Atom, an das sie gebunden sind, Pyrrolidinyl, Piperidyl, Morpholinyl oder Thiomorpholinyl bilden, und R₅ bis R₈ unabhängig voneinander Wasserstoff, Chlor oder Brom bedeuten.

Am meisten bevorzugt werden Verbindungen der Formel I, worin R₁ und R₂ 2-, 3- oder insbesondere 4-Pyridyl bedeuten, und X₁ und X₂ für O stehen, oder worin R₁ und R₂ eine Gruppe 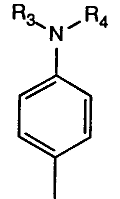
bedeuten, R₃ und R₄ je Methyl sind oder zusammen mit dem N-Atom, an das sie gebunden sind, Pyrrolidinyl, Piperidyl oder Morpholinyl bilden, und X₁ und X₂ gleich sind und O oder vorzugsweise S bedeuten.

Ganz besonders bevorzugte Verbindungen der Formel I sind 1,4-Diketo-3,6-bis-(4′-pyridyl)-pyrrolo-[3,4-c]-pyrrol, 1,4-Diketo-3,6-bis-(3′-pyridyl)-pyrrolo-[3,4-c]-pyrrol und 1,4-Dithioketo-3,6-bis-(4′-dimethylaminophenyl)-pyrrolo-[3,4-c]-pyrrol.

Gemische von Pyrrolopyrrolen obiger Strukturen können ebenfalls verwendet werden.

Ein weiterer Gegenstand der Erfindung ist ein Verfahren zur Speicherung von Informationen in einem erfindungsgemässen beschichteten Material, in dem die Schicht aus Verbindungen der Formel I mit Salzen von starken Säuren als Aufzeichnungsschicht dient, das dadurch gekennzeichnet ist, dass die Aufzeichnungsschicht mit Laserstrahlen entsprechend der Form der zu markierenden Information bestrahlt und das Absorptionsspektrum der Aufzeichnungsschicht so verändert wird, dass an den bestrahlten Stellen dieser Schicht Informationen aufgezeichnet und gespeichert werden.

Das erfindungsgemässe Verfahren basiert auf der überraschenden Tatsache, dass Verbindungen der Formel I im festen Zustand, zum Beispiel in Form einer dünnen Schicht auf einem Substrat, durch Einwirkung von Säuredämpfen eine batho- oder hypsochrome Verschiebung des Absorptionsmaximums erfahren. Im allgemeinen bewirkt die Protonierung von Verbindungen der Formel I mit R₁ und R₂ gleich Pyridyl eine bathochrome Verschiebung, während es bei Verbindungen, worin R₁ und R₂ einen mit einer tert. Aminogruppe substituierten Rest darstellen, zu einer hypsochromen Verschiebung kommt. Die so erhaltene andersfarbige Form zeichnet sich durch eine hohe Lichtstabilität aus, kann aber wenn zweckmässig durch Erwärmen, beispielsweise bei einer Temperatur von etwa 150°C, wieder in die ursprüngliche Form ohne Salze mit starken Säuren übergeführt werden, wobei es in den erwärmten Bereichen selektiv zu einer hypso- oder bathochromen Farbänderung kommt. Der oben beschriebene Prozess ist reversibel und kann beliebig wiederholt werden. Am Beispiel der Verbindung der Formel I, worin R₁ und R₂ für 4-Pyridyl stehen und X₁ und X₂ O bedeuten, kann er wie folgt dargestellt werden:

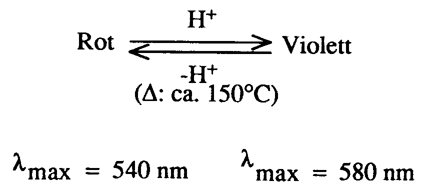

Das Aufbringen der Information erfolgt durch Beschriftung der violetten Form mit einem Laser. Die absorbierte Lichtenergie wird dabei in thermische Energie umgewandelt und an den bestrahlten Stellen kommt es zu einer Deprotonierung und Farbänderung. Die so erzeugte und gespeicherte Information kann beliebig wiederholbar optisch gelesen werden oder, falls erwünscht, durch nicht selektive Erwärmung der gesamten Schicht wieder gelöscht werden.

Mit dem erfindungsgemässen Verfahren kann eine hohe Speicherdichte erreicht werden. So ist ohne weiteres eine Punktgrösse ("Pixel") von unter einem µm² möglich.

Die im Aufzeichnungsverfahren verwendeten erfindungsgemässen Materialien können je nach Art des Funktionsprinzips (Transmission oder Reflexion) unterschiedlich aufgebaut sein. Wenn das Aufzeichnungssystem gemäss einer Veränderung der Lichttransmission funktioniert, kommt die folgende Struktur in Frage: Durchsichtiger Träger/Aufzeichnungsschicht/falls zweckmässig, durchsichtige Schutzschicht. Das Licht zur Aufzeichnung sowie zum Ablesen kann entweder von der Trägerseite oder der Aufzeichnungsschicht bzw. gegebenenfalls der Schutzschichtseite eingestrahlt werden, wobei sich der Lichtdetektor immer auf der Gegenseite befindet.

Funktioniert das Aufzeichnungsverfahren gemäss einer Veränderung der Reflexion, so kommen folgende andere Strukturen für einen erfindungsgemässen Träger zur Anwendung: Durchsichtiges Träger/Aufzeichnungsschich/Reflexionsschicht/falls zweckmässig, Schutzschicht (nicht unbedingt durchsichtig), oder Träger (nicht unbedingt durchsichtig)/Reflexionsschicht/Aufzeichungsschicht/falls zweckmässig durchsichtige Schutzschicht. Im ersten Fall wird das Licht von der Trägerseite eingestrahlt, während im letzten Fall die Strahlung von der Aufzeichnungsschicht- bzw. gegebenenfalls von der Schutzschichtseite einfällt. In beiden Fällen befindet sich der Lichtdetektor auf gleicher Seite wie die Lichtquelle. Der ersterwähnte Schichtaufbau ist im allgemeinen bevorzugt.

Die Herstellung der Pyrrolopyrrolschicht für erfindungsgemässe Materialien erfolgt vorteilhaft durch Aufdampfen oder Sputtern im Hochvakuum. Hierbei wird ein Pyrrolopyrrol oder ein Gemisch von Pyrrolopyrrolen unter Hochvakuum auf einen Träger aufgedampft oder gesputtert und anschliessend mit Säuredampf protoniert. Zwei oder mehrere verschiedene Pyrrolopyrrole können unter Verwendung von zwei oder mehreren Verdampfungsquellen gleichzeitig oder stufenweise, Schicht für Schicht (also Multi-Schicht) aufgedampft werden. Nach dem Aufdampfen werden die Salze starker Säuren zweckmässig durch Behandeln der Schicht mit Säuredämpfen erzeugt. Die Dicke der Aufzeichnungsschicht kann im breiten Rahmen variieren; vorzugsweise ist die Schicht 200 bis 3000Å, insbesondere 500 bis 1200 Å dick. Besonders bevorzugt liegt die Schichtdicke bei etwa 700 bis 1000 Å.

Als Träger kommen bei der Verwendung als Informationsaufzeichnungsmaterial z.B. Glas, Polycarbonate, Polymethymethacrylate, Polyolefine oder Epoxyharze in Frage. Beliebige Metalle, z.B. Metallplatten, -filme oder -folien aus z.B. Aluminium, ferner metallbedampfte Kunststofffolien und -filme können auch verwendet werden.

Die lichtreflektierende Schicht sollte so beschaffen sein, dass diese das zum abtastenden Lesen verwendete Licht möglichst quantitativ reflektiert. Geeignete lichtreflektierende Materialien sind z.B. Aluminium, Gold, Platin, Nickel, Silber, Rhodium, Zinn, Blei, Wismut und Kupfer. Bevorzugt sind Aluminium und Gold Diese Materialien können unter Hochvakuum mit Hilfe der Aufdampf- oder Sputtertechnik auf einem Aufzeichnungsträger aufgebracht werden. Die Dicke der lichtreflektierenden Schicht soll so gross sein, dass diese das zum Abtasten benutzte Licht möglichst vollständig reflektiert. So ist die Schicht vorzugsweise 1000 bis 3500 Å, insbesondere etwa 2000 Å dick. Für diesen Zweck sind Spiegel mit hoher Reflexion bei der in Frage kommenden Wellenlänge vorteilhaft Die lichtreflektierende Schicht weist vorteilhaft eine optisch glatte, ebene Oberfläche auf und ist an der Oberfläche so beschaffen, dass die Aufzeichnungsschicht darauf fest haftet.

Wie bereits oben gesagt, kann das Aufbringen der erfindungsgemässen Aufzeichnungsschicht und der metallischen Reflexionsschichten durch Aufdampfen im Vakuum erfolgen. Das aufzubringende Material wird zunächst in ein geeignetes Gefäss gegebenenfalls mit einer Widerstandsheizung gefüllt und in eine Vakuumkammer gesetzt. Der zu bedampfende Träger wird oberhalb des Gefässes mit dem aufzudampfenden Material in einen Halter eingesetzt. Dieser ist so konstruiert, dass der Träger gegebenenfalls rotiert (z.B. mit 50 Upm) und geheizt werden kann. Die Vakuumkammer wird auf etwa 1,3 ·10⁻⁵ bis 1,3 · 10⁻⁶ mbar (10⁻⁵ bis 10⁻⁶ Torr) evakuiert, und die Heizung wird so eingestellt, dass die Temperatur des aufzudampfenden Materials bis zu dessen Verdampfungstemperatur ansteigt. Die Verdampfung wird so lange fortgesetzt, bis die aufgedampfte Schicht die gewünschte Dicke hat. Je nach Systemaufbau wird zuerst die organische Aufzeichnungsverbindung und dann die reflektierende Schicht aufgebracht, oder es kann umgekehrt verfahren werden. Auf das Aufbringen einer reflektierenden Schicht kann gegebenenfalls verzichtet werden.

Die Sputtertechnik wird besonders wegen der hohen Haftfähigkeit zum Träger für das Aufbringen der metallischen Reflexionsschicht bevorzugt, Das aufzubringende Material (z.B. Aluminium) in Form einer Platte wird als eine "Target"-Elektrode benutzt, während der Träger auf der Gegenelektrode befestigt wird. Zuerst wird die Vakuumkammer auf etwa 10⁻⁶ Torr evakuiert und dann inertes Gas, wie z.B. Argon, bis zu etwa 10⁻³ Torr eingeführt. Zwischen der "Target"-Elektrode und der Gegenelektrode wird eine hohe Gleich- oder Radiofrequenz-Spannung von mehreren kV, gegebenenfalls unter Verwendung von Permanentmagneten ("Magnetron-Sputtering"), angelegt, um Ar⁺-Plasma zu erzeugen. Die durch die Ar+-Ionen von der "Target"-Elektrode gesputterten (herausgeschlagenen) Metallteilchen werden auf dem Träger gleichmässig und fest deponiert. Die Beschichtung erfolgt innerhalb von einigen bis mehreren Minuten je nach Targetmaterialien, Sputtermethode und Sputterbedingungen. Diese Sputtertechnik ist in Fachbüchern ausführlich beschrieben (z.B. W. Kern und L. Vossen, "Thin Film Processes", Academic Press, 1978).

Die Dicke der beim Aufdampfen gebildeten Schicht kann mit Hilfe bekannter Verfahren überwacht werden, z.B. mit Hilfe eines optischen Systems, welches während der Aufdampfung das Reflexionsvermögen der mit dem Absorptionsmaterial bedeckten Reflexionsoberfläche misst. Vorzugsweise wird das Wachsen der Schichtdicke mit einem Schwingquarz verfolgt.

Das Aufzeichnungssystem kann auch noch weitere Farbmittel, wie anorganische oder organische Pigmente, oder gegebenenfalls anorganische oder organische adiabatische Schichten enthalten, die gegenüber der erfindungsgemäss vorgenommenen Säuredampfbehandlung inaktiv sind.

Wie oben erwähnt, kann, falls zweckmässig auf die Aufzeichnungsschicht oder lichtreflektierende Schicht eine Schutzschicht, welche die Aufzeichnung und das Ablesen der Information nicht beeinträchtigt, aufgetragen werden. Im allgemeinen wird diese Ausführungsform bevorzugt. Geeignete Schutzschichten sind z.B. UV-vernetzbare Polymere basierend auf Polyacrylaten wie z.B. RENGOLUX® RZ 3200/003 sowie 3203/001 der Firma Morton International-Dr. Renger oder SD-17® der Firma DIC.. Der Schutzlack wird geeigneterweise mit einer Belackungsanlage ("spin coater") beschichtet und mit UV-Licht vernetzt. Die Schichtdicke liegt vorzugsweise bei 5-20 µm, insbesondere bei 8-10 µm.

Für die Aufzeichnung der Information auf die Aufzeichnungsschicht sind, wie gesagt, Laser geeignet, wie z.B. He-Ne Laser (633 nm), Argon-Laser (514 nm) oder Diodenlaser auf Basis von GaAsAl (780 nm), GaAs (830 nm) und InGaAlP (650 nm). Die Aufzeichnung kann mit Hilfe eines Lichtmodulators punktweise (Punkt für Punkt) oder linienweise durchgeführt werden.

Das erfindungsgemässe Verfahren ermöglicht eine Aufzeichnung/Speicherung von Informationen, geprägt durch saubere Randzonen, hohe Zuverlässigkeit und ein niedrieges Signal-Rauschverhältnis. Die gespeicherten Informationen sind gut lesbar, und das Aufzeichnungssystem ist deformationsstabil, licht- und wetterbeständig und ist ferner gegenüber Temperaturveränderungen und UV-Strahlen sehr beständig.

Wie oben bereits erwähnt, tritt nach dem vorliegenden Verfahren an der (den) bestrahlten Stelle(n) des Aufzeichnungsmaterials eine Veränderung im Absorptionsspektrum ein. Die Veränderung im Absorptionsspektrum bzw. die gespeicherte Information kann mit einem Photodetektor unter Verwendung eines energiearmen Lasers abgelesen werden. Geeignete Photodetektoren umfassen zum Beispiel PIN-Dioden, welche es ermöglichen, die spekträlen Veränderungen durch Transmission oder Absorption und insbesondere Reflexion zu messen.

So zeigt z.B. 1,4-Diketo-3,6-bis-(4′-pyridyl)-pyrrolo-[3,4-c]-pyyrol nach Belichtung eine visuelle Farbveränderung von violett nach rot (Verschiebung der Absorption von ca. 580 auf ca. 540 nm), das entsprechende 3′-Pyridyl-Derivat eine spektrale Veränderung von etwa 550 nm auf etwa 535 nm, und 1,4-Dithioketo-3,6-bis-(4′-dimethylaminophenyl)-pyrrolo-[3,4-c]-pyrrol eine spektrale Veränderung von ca. 630 nm auf ca. 740 nm.

Ein weiterer Gegenstand der Erfindung ist die Verwendung des erfindungsgemässen beschichteten Trägers als optisches Aufzeichnungsmaterial.

Ein anderer Gegenstand der Erfindung ist ein Informationen enthaltendes beschichtetes Material, bei welchem die Aufzeichnungsschicht aus Verbindungen der Formel I besteht, die mindestens teilweise Salze starker Säuren sind, und diese Aufzeichnungsschicht Informationen in Form von Bits enthält, die eine höhere oder niedrigere Absorption aufweisen, als ihre Umgebung in der Aufzeichnungsschicht.

Auf Grund der elektrischen Leitfähigkeit und der Photoleitfähigkeit sind weitere Anwendungen möglich. Die Leitfähigkeit kann hierbei durch Behandlung der Salze starker Säuren enthaltenden Schicht aus Verbindungen der Formel I mit Halogenen, besonders Brom und Iod, noch erheblich verbessert werden.

Die erfindungsgemäss definierten Pyrrolopyrrol-Verbindungen der Formel I können in Form von Salzen starker Säuren auch zur antistatischen Ausrüstung von dielektrischen Substraten verwendet werden, wobei es sich dann bei dem Träger um ein dielektrisches Subsaat handelt. Diese Verwendung stellt einen weiteren Gegenstand der Erfindung dar. Die Schichtdicke der Pyrrolopyrrol-Verbindungen in Form von Salzen starker Säuren beträgt bei dieser Verwendung bevorzugt 500 bis 5000 Å, besonders bevorzugt 800 bis 4000 Å und insbesondere bevorzugt 1000 bis 3000 Å.

Auf Grund der Photoleitfähigkeit eignet sich das erfindungsgemässe beschichtete Material auch zur Herstellung von Photorezeptoren. Hierbei besteht der Träger aus einem elektrisch leitenden Material, zum Beispiel einem Metall wie Aluminium, und auf der Schicht der Pyrrolopyrrol-Verbindungen der Formel I in Form von Salzen starker Säuren befindet sich eine ladungstransportierende Schicht. Die Verwendung und Herstellung solcher Photorezeptoren und Materialien für die ladungsaansportierende Schicht sind dem Fachmann geläufig und zum Beispiel in der US-A-4 632 893 beschrieben. Die Photorezeptoren sind ein weiterer Gegenstand der Erfindung. Die Schichtdicke der Pyrrolopyrrol-Verbindungen in Form von Salzen starker Säuren beträgt bei dieser Verwendung bevorzugt 500 bis 4000 Å, besonders bevorzugt 800 bis 3000 Å und insbesondere bevorzugt 1000 bis 2500 Å. Solche Photorezeptoren werden zum Beispiel in der Xerographietechnik verwendet.

Das erfindungsgemässe beschichtete Material eignet sich auch zur Herstellung von Solarzellen beziehungsweise Solarbatterien. Der Träger besteht hierbei aus einem transparenten elektrischen Material, zum Beispiel aus mit elektrisch leitenden Indium/Zinn-Oxid (ITO) oder mit dünnen Metallschichten beschichteten Gläsern, die als tranparente Elektroden dienen, und auf der Schicht der Pyrrolopyrrol-Verbindungen der Formel I in Form von Salzen starker Säuren befindet sich eine weitere Elektrode aus einem elektrischen Leiter, zum Beispiel Aluminium, Kupfer oder Gold. Eine zur Ladungstrennung dienende Schottky-Barriere wird hierbei zwischen der Schicht des Photoleiters und einer der Elektroden angebracht. Solche Solarbatterien sind ein weiterer Gegenstand der Erfindung. Die Schicht von Pyrrolopyrrol-Verbindungen der Formel I in Form von Salzen starker Säuren weist hierbei bevorzugt eine Dicke von 500 bis 3000 Å, besonders bevorzugt von 500 bis 2000 Å und insbesondere bevorzugt von 500 bis 1500 Å auf.

Ein mit Pyrrolopyrrol-Verbindungen der Formel I beschichteter Träger eignet sich auch zur Herstellung von Sensoren. Hierbei ist der Träger zweckmässig ebenfalls als Elektrode ausgebildet, vorteilhaft mit zwei gesennten Elektroden. Besonders vorteilhaft ist es, je eine ineinander greifende kammartige Kathode und Anode auf der Oberfläche aufzubringen, auf denen sich die Schicht aus Pyrrolopyrrol-Verbindungen der Formel I befindet. Die durch eine Salzbildung verursachte Veränderung der Leitfähigkeit vor und nach dem Kontakt mit Säuren kann zum Beispiel durch eine Messung der Widerstände vor und nach der Behandlung mit Säuren bestimmt werden. Die Schicht aus Pyrrolopyrrol-Verbindungen der Formel I ist somit die aktive Schicht. Ein weiterer Gegenstand der Erfindung sind solche als Sensoren ausgebildete Träger. Die Schicht von Pyrrolopyrrol-Verbindungen der Formel I weist hierbei bevorzugt eine Dicke von 500 bis 3000 Å, besonders bevorzugt von 500 bis 2000 Å und insbesondere bevorzugt von 500 bis 1500 Å auf.

Die folgenden Beispiele erläutern die Erfindung.

### Beispiel 1:

Aluminium wird unter Hochvakuum in einer Schichtdicke von etwa 2500 Å auf ein Glassubstrat aufgedampft. 1,4-Diketo-3,6-bis-(4′-pyridyl)-pyrrolo-[3,4-c]-pyrrol wird dann unter den gleichen Bedingungen auf die Aluminiumschicht in einer Schichtdicke von etwa 1000 Å aufgedampft. Die so hergestellte Aufzeichnungsplatte wird während etwa 5 Sekunden Salpetersäuredämpfen ausgesetzt, wobei es zu einer bathochromen Verschiebung kommt (Absorptionsmaximum: 540 bis 580 nm). Elektronische Information wird unter Verwendung eines Ar⁺-Lasers der Wellenlänge von 514 nm punktweise aufgezeichnet und die Aenderung der Reflexion wird bei 600 nm mit einem Mikroskop-Spektrophotometer (Carl Zeiss: UMSP 80) gemessen. Die Reflexion vor und nach der Beschriftung beträgt etwa 5 bzw. etwa 53 %.

### Beispiel 2:

Beispiel 1 wird wiederholt, indem statt 1,4-Diketo-3,6-bis-(4′-pyridyl)pyrrolo-[3,4-c]-pyrrol 1,4-Diketo-3,6-bis-(3′-pyridyl)-pyrrolo-[3,4-c]-pyrrol einer Schichtdicke von etwa 700 Å verwendet wird. Die Reflexion wird bei 580 nm gemessen und beträgt vor und nach der Beschriftung etwa 25 bzw. etwa 61 %.

### Beispiel 3:

Beispiel 1 wird wiederholt, indem statt 1,4-Diketo-3,6-bis-(4′-pyridyl)pyrrolo-[3,4-c]-pyrrol 1,4-Dithioketo-3,6-bis-(4′-dimethylaminophenyl)-pyrrolo- [3,4-c]-pyrrol einer Schichtdicke von 900 Å verwendet wird. Die Information wird mit einer Laserdiode der Wellenlänge von 780 nm aufgezeichnet und die Reflexion wird bei 780 nm mit einer PIN-Diode gemessen. Die Reflexion vor und nach der Beschriftung beträgt etwa 6 bzw. etwa 52 %.

### Beispiel 4: Herstellung eines Photorezeptors.

1,4-Diketo-3,6-bis-(4′-pyridyl)-pyrrolo-[3,4-c]-pyrrol wird als Ladungen erzeugendes Material unter Hochvakuum auf einen Aluminiumträger in einer Schichtdicke von etwa 1500 Å aufgedampft und anschliessend 5 sek den Dämpfen von konzentrierter Salpetersäure ausgesetzt. Dann wird mit einer Lösung von Polycarbonat und 4-Diethylaminobenzaldehyd-1,1-diphenylhydrazon (1: 1 Gewichtsanteile) in CHCl₃ eine 20 µm dicke Schicht aus Polycarbonat und 4-Diethylaminobenzaldehyd-1,1-diphenylhydrazon (1: 1) als Ladung transportierendes Material aufgebracht. Das Ladungs- und Entladungsverhalten bei Lichtbestrahlung wird mit einem "Paper Analyzer" der Firma Kawaguchi Denki (Modell SP-428) bestimmt. Die Ladungsaufnahme beträgt -1200 V und die Photosensibilität E_{1/2} beträgt im sichtbaren Bereich 3 Lux·sek (E_{1/2} bedeutet die reziproke Energie für die Erniedrigung des Oberflächenpotentials auf die Hälfte des Ursprungswerts).

### Beispiel 5: Herstellung eines Sensors.

Ein Glasträger, auf dessen Oberfläche zwei kammartige ineinandergreifende Elektroden aus Gold aufgebracht sind, wird unter Hochvakuum mit einer 800 Å dicken Schicht aus 1,4-Diketo-3,6-bis-(4′-pyridyl)-pyrrolo-[3,4-c]-pyrrol beschichtet. Eine Batterie (6 V) und ein Widerstand (100 kΩ) wird mit diesem Sensor in Serie geschalten. Die Erniedrigung des Widerstandes durch Behandlung des Sensors mit Dämpfen von konzentrierter Salpetersäure wird durch die Messung der Spannung am Widerstand bestimmt. Die Spannung ändert sich von 6 µV (unbehandelt) auf 600 mV.

### Beispiel 6: Bestimmung der antistatischen Eigenschaft.

1,4-Diketo-3,6-bis-(4′-pyridyl)-pyrrolo-[3,4-c]-pyrrol wird unter Hochvakuum in einer Schichtdicke von 2000 Å auf einen Träger aus Aluminium aufgedampft und mit dem "Paper Analyzer" gemäss Beispiel 4 die positive und negative Aufladung vor und nach der Behandlung mit Salpetersäuredämpfen gemessen. Das negative Potential ist 1000 V beziehungsweise 5 V und das positive Potential 800 V beziehungsweise 8 V.

## Patentansprüche

1. Beschichtetes Material, bei dem ein Träger auf mindestens einer Seite mit einer dünnen Schicht eines Pyrrolopyrrols der Formel I oder Mischungen von Pyrrolopyrrolen der Formel I beschichtet ist, 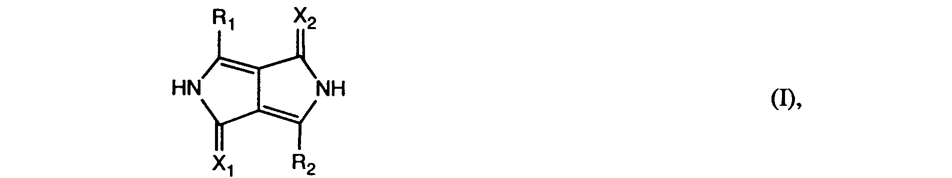 worin R₁ einen mit einer tert. Aminogruppe substituierten Phenyl- oder Pyridylrest der Formeln 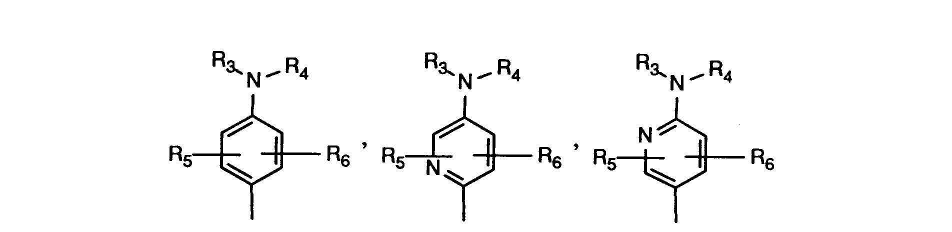 bedeutet oder eine Pyridylgruppe der Formel 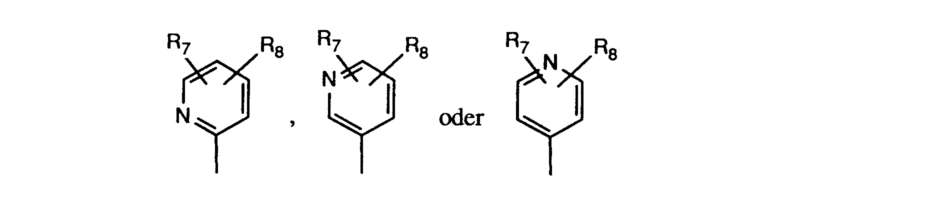 ist, R₂ eine Gruppe 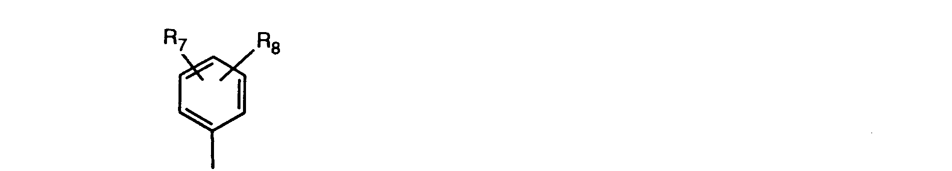 ist oder die gleiche Bedeutung wie R₁ hat, R₃ und Rq unabhängig voneinander C₁-C₁₈-Alkyl, C₅-C₆-Cycloalkyl, durch -OH oder -SH substituiertes C₁-C₁₈-Alkyl oder unsubstituiertes oder durch Halogen, C₁-C₁₂-Alkyl, C₁-C₁₂-Alkoxy, Cyano oder Nitro substituiertes Phenyl, Benzyl oder Phenylethyl bedeuten oder zusammen mit dem N-Atom, an das sie gebunden sind, einen 5- oder 6-gliedrigen heterocyclischen Rest ausgewählt aus der Gruppe bestehend aus Pyrrolidinyl, Piperidyl, Pyrrolyl, Imidazolyl, Pyrazolyl, Triazolyl, Piperazinyl, Morpholinyl und Thiomorpholinyl bilden,
R₅ bis R₈ unabhängig voneinander Wasserstoff, Halogen, C₁-C₁₂-Alkyl, C₁-C₁₂-Alkoxy, C₁-C₁₂-Alkylmerkapto oder Cyano bedeuten, und X₁ und X₂ unabhängig voneinander O oder S sind, wobei die Verbindungen der Formel I zumindest teilweise in Salze von starken Säuren übergeführt sind.

2. Material nach Anspruch 1, dadurch gekennzeichnet, dass jeweils die Gruppen R₁ und R₂ bzw. X₁ und X₂ in den Verbindungen der Formel I gleich sind.

3. Material nach Anspruche 1, dadurch gekennzeichnet, dass jeweils die Gruppen R₃ und R₄, R₅ und R₆ bzw. R₇ und R₈ in den Verbindungen der Formel I gleich sind.

4. Material nach Anspruch 1, dadurch gekennzeichnet, dass R₁ Pyridyl oder eine Gruppe 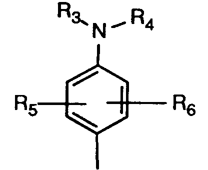 und R₂ eine Gruppe 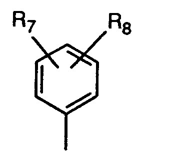 oder R₁ bedeuten, worin R₃ und R₄ gleich sind und C₁-C₁₂-Alkyl, 2-Hydroxyethyl, 2-Mercaptoethyl, Cyclohexyl, Benzyl oder Phenylethyl bedeuten oder zusammen mit dem N-Atom, an das sie gebunden sind, Pyrrolidinyl, Piperidyl, Morpholinyl oder Thiomorpholinyl bilden, und R₅ bis R₉ unabhängig voneinander Wasserstoff, Chlor, Brom, C₁-C₄-Alkyl oder C₁-C₄-Alkoxy oder C₁-C₄-Alkylmerkapto bedeuten.

5. Material nach Anspruche 1, dadurch gekennzeichnet, dass R₃ und R₄ gleich sind und C₁-C₄-Alkyl, 2-Hydroxyethyl oder 2-Mercaptoethyl bedeuten oder zusammen mit dem N-Atom, an das sie gebunden sind, Pyrrolidinyl, Piperidyl, Morpholinyl oder Thiomorpholinyl bilden, und R₅ bis R₈ unabhängig voneinander Wasserstoff, Chlor oder Brom bedeuten.

6. Material nach Anspruch 1, dadurch gekennzeichnet, dass R₁ und R₂ 2-, 3- oder 4-Pyridyl bedeuten, und X₁ und X₂ für O stehen, oder worin R₁ und R₂ eine Gruppe 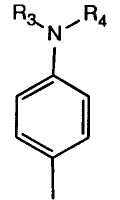 bedeuten, R₃ und R₄ je Methyl sind oder zusammen mit dem N-Atom, an das sie gebunden sind, Pyrrolidinyl, Piperidyl oder Morpholinyl bilden, und X₁ und X₂ gleich sind und O oder vorzugsweise S bedeuten.

7. Material nach Anspruch 1, dadurch gekennzeichnet, dass die Schicht aus Pyrrolopyrrolen mindestens teilweise Salze mit Salpetersäure, Salzsäure, Bromwasserstoffsäure, Trichloressigsäure oder Trifluoressigsäure bildet.

8. Material nach Anspruch 1, dadurch gekennzeichnet, dass die Schicht aus den Verbindungen der Formel I eine Dicke von 500 bis 5000 Å aufweist.

9. Material nach Anspruch 1, dadurch gekennzeichnet, dass der Träger aus Papier, Glas, Keramiken, Kunststoffen, Laminaten, Metallen, Metallegierungen oder Metalloxiden besteht.

10. Material nach Anspruch 1, dadurch gekennzeichnet, dass dass es sich bei den Verbindungen der Formel I um 1,4-Diketo-3,6-bis-(4′-pyridyl)-pyrrolo-[3,4-c]-pyrrol, 1,4-Diketo-3,6-bis-(3′-pyridyl)-pyrrolo-[3,4-c]-pyrrol und 1,4-Dithioketo-3,6-bis-(4′-dimethylaminophenyl)-pyrrolo-[3,4-c]-pyrrolo handelt.

11. Verfahren zur Herstellung des beschichteten Materials gemäss Anspruch 1, bei dem man einen Träger, von dem mindestens eine Oberfläche mit einem Pyrrolopyrrol der Formel I beschichtet ist, mit einer starken Säure in Kontakt bringt und die Pyrrolopyrrole der Formel I mindestens teilweise in Salze besagter Säuren überführt.

12. Verfahren gemäss Anspruch 11, dadurch gekennzeichnet, dass den beschichteten Träger Dämpfen von starken Säuren aussetzt.

13. Verfahren zur Speicherung von Informationen in einem beschichteten Material gemäss Anspruch 1, in dem die Schicht aus Verbindungen der Formel I mit Salzen von starken Säuren als Aufzeichnungsschicht dient, dadurch gekennzeichnet, dass die Aufzeichnungsschicht mit Laserstrahlen entsprechend der Form der zu markierenden Information bestrahlt und das Absorptionsspektrum der Aufzeichnungsschicht so verändert wird, dass an den bestrahlten Stellen dieser Schicht Informationen aufgezeichnet und gespeichert werden.

14. Verfahren gemäss Anspruch 13, dadurch gekennzeichnet, dass das beschichtete Material den Aufbau transparenten Träger/Aufzeichnungsschicht/gegebenenfalls transparente Schutzschicht aufweist.

15. Verfahren gemäss Anspruch 13, dadurch gekennzeichnet, dass das beschichtete Material den Aufbau transparenten Träger/Aufzeichnungsschicht/Reflexionsschicht/Schutzschicht aufweist.

16. Verfahren gemäss Anspruch 13, dadurch gekennzeichnet, dass das beschichtete Material den Aufbau transparenten Träger/Reflexionsschicht/Aufzeichnungsschicht/gegebenenfalls transparente Schutzschicht aufweist.

17. Verfahren gemäss Anspruch 13, dadurch gekennzeichnet, dass man die durch Bestrahlung mit Laserstrahlen gespeicherte Information mit einem Photodetektor unter Verwendung eines energiearmen Lasers ausliest.

18. Informationen enthaltendes beschichtetes Material, bei welchem die Aufzeichnungsschicht aus Verbindungen der Formel I besteht, die mindestens teilweise Salze starker Säuren sind, und diese Aufzeichnungsschicht Informationen in Form von Bits enthält, die eine höhere oder niedrigere Absorption aufweisen, als ihre Umgebung in der Aufzeichnungsschicht.

19. Antistatisch ausgerüstetes Material gemäss Anspruch 1, dadurch gekennzeichnet, dass es sich bei dem Träger um ein dielektrisches Material handelt.

20. Photorezeptoren aus einem Material gemäss Anspruch 1, dadurch gekennzeichnet, dass der Träger aus einem elektrisch leitenden Material besteht und dass auf der Schicht der Pyrrolopyrrole der Formel I, die mindestens teilweise als Salze starker Säuren vorliegen, zusätzlich eine ladungstransportierende Schicht aufgebracht ist.

21. Solarzellen und Solarbatterien aus einem Material gemäss Anspruch 1, dadurch gekennzeichnet, dass der Träger aus einem transparenten elektrisch leitenden Material besteht, und dass auf der Schicht der Pyrrolopyrrole der Formel I, die mindestens teilweise als Salze starker Säuren vorliegen, zusätzlich eine Elektrode aufgebracht ist.

22. Sensor aus einem beschichteten Material, dadurch gekennzeichnet, dass der Träger ein mit zwei Elektroden beschichtetes Material ist, auf denen eine Schicht aus Pyrrolopyrrolen der Formel I aufgebracht ist.

23. Verwendung des Materials gemäss Anspruch 1 als optisches Aufzeichnungsmaterial, zur Herstellung von Solarbatterien und Solarzellen und zur Herstellung von Photorezeptoren.

24. Verwendung des beschichteten Materials gemäss Anspruch 1 mit einem dielektrischen Träger als antistatisch ausgerüstetes Material.

25. Verwendung eines mit Pyrrolopyrrolen der Formel I beschichteten Materials als Sensor, wobei der Träger mit zwei Elektroden beschichtet ist und die Pyrrolopyrrole der Formel I als aktive Schicht dienen.
